Europäisches Patentamt

European Patent Office

Office européen des brevets

(11) Publication number: **0 078 684**
**B1**

# EUROPEAN PATENT SPECIFICATION

(45) Date of publication of patent specification: **27.07.88**

(51) Int. Cl.⁴: **H 01 L 23/04, H 01 L 23/48,**
**H 01 L 23/36, H 01 L 23/14**

(21) Application number: **82305775.7**

(22) Date of filing: **29.10.82**

(54) A semiconductor device having a leadless chip carrier.

(30) Priority: **30.10.81 JP 173953/81**

(43) Date of publication of application:
**11.05.83 Bulletin 83/19**

(45) Publication of the grant of the patent:
**27.07.88 Bulletin 88/30**

(84) Designated Contracting States:
**DE FR GB**

(56) References cited:
**EP-A-0 028 802**
**FR-A-2 181 892**
**GB-A-2 056 772**
**US-A-3 972 062**
**US-A-4 025 997**

(73) Proprietor: **FUJITSU LIMITED**
**1015, Kamikodanaka Nakahara-ku**
**Kawasaki-shi Kanagawa 211 (JP)**

(72) Inventor: **Mizuo, Masahiko**
**7-8, Kaijin, 4-chome**
**Funabashi-shi Chiba 273 (JP)**

(74) Representative: **Fane, Christopher Robin King**
**et al**
**HASELTINE LAKE & CO. Hazlitt House 28**
**Southampton Buildings Chancery Lane**
**London, WC2A 1AT (GB)**

## Description

The present invention relates to semiconductor devices.

The increasingly large scale of computer systems has brought along with it a sharp rise in the number of semiconductor elements, for example semiconductor memory elements, used per system. This would normally cause a drop in computing speed, due to the increased wiring length, and larger system external dimensions. As a means to prevent this, large numbers of packaged semiconductor memory elements have begun to be used in recent times.

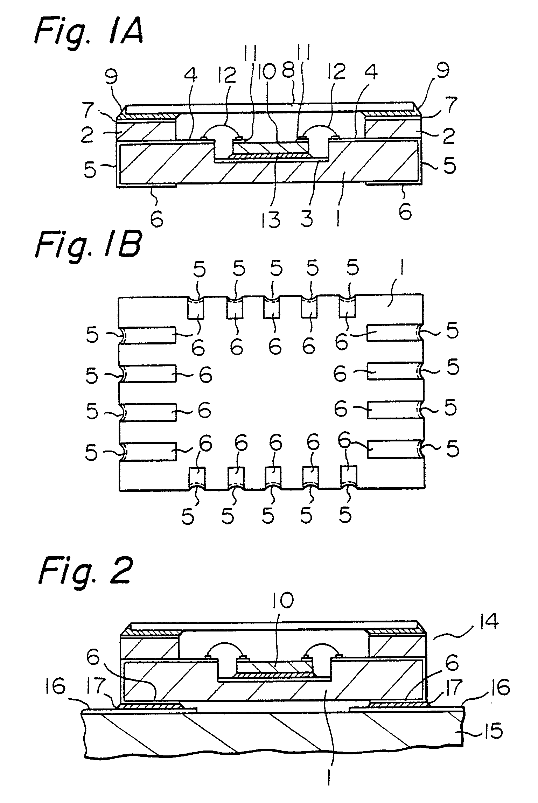

Figure 1A of the accompanying drawings shows diagramatically a cross-sectional view of a conventional packaged semiconductor memory element with a chip carrier of the "leadless" (or "pin-free")type, and Figure 1B shows an underneath plan view corresponding to Fig. 1A.

Referring to Fig. 1A a ceramic substrate 1 is employed as a plate-form support member which is provided on one main face thereof with a ceramic frame 2. Inner connections 4 surface portions of which are plated for example with gold, connect with outer connections 5, also plated for example with gold, which connect to terminals 6 provided at the other (bottom) main face of the ceramic substrate 1. A cap 8 made of, for example, metal is connected to the ceramic frame 2 through cap-soldering metallized layer 7 and through a soldering material 9 of, for example, brazing alloy. In a recessed portion of the upper main face of the substrate 1, a semiconductor chip 10, for example a semi-conductor memory chip, is mounted by means of a gold/ silicon layer 13 on a gold-plated chip stage 3. Bonding pads 11 constituting terminals of the semiconductor memory chip 10 are electrically connected to the inner connections 4 through bonding wire 12. Thus, the semiconductor memory chip 10 is protected from mechanical impact and the harmful surrounding atmosphere.

Referring to Fig. 1B, the bottom of the ceramic substrate 1 is provided with a plurality of strip shaped terminals 6, whose exposed surfaces are plated with gold, in electrical connection with the outer connections 5.

Figure 2 is a schematic cross-sectional view illustrating a conventional packaged semiconductor memory element shown in Fig. 1A, and referred to here by the numeral 14, on a connection substrate 15.

The packaged semiconductor memory element 14 comprises a cap 8, a semiconductor memory chip 10, ceramic substrate 1, which is a leadless chip carrier; and chip selecting terminals.

As shown in Fig. 2, the packaged semiconductor memory element 14 is mounted on a connection pattern 16 provided on the connection substrate 15 by soldering the terminals 6 at the bottom of the packaged semiconductor memory element 14 onto the connection pattern 16. The soldered portion is illustrated by reference numeral 17 in Fig. 2. Thus, in this conventional structure of a packaged semiconductor memory element, the region wherein the semiconductor memory element contacts the connection substrate 15 is very small, since the region is only a portion of the terminals 6 at the bottom of the packaged semiconductor memory element 14.

When the packaged semiconductor memory is working, the semiconductor memory chip 10 usually becomes heated. Some of this heat is conducted to the ceramic substrate 1. A small part of heat generated in the semiconductor memory chip 10, therefore, is conducted to the connection substrate 15 through the ceramic substrate 1. Most of the heat generated in the semiconductor memory chip 10, however, remains where it is, though some further heat is emitted from the surface of the semiconductor memory chip 10 to the surrounding atmosphere. Therefore, the semiconductor memory chip 10 is only poorly cooled or heat sunk.

The increased temperature of the semiconductor memory chip 10 raises the temperature of the surrounding atmosphere, further reducing the effect of cooling or heat sinking of the semiconductor memory chip 10.

This results in a higher temperature of the packaged semiconductor memory element 14 and may impair the functioning thereof. To alleviate this problem, space may be provided between semiconductor memory chips to increase the cooling or heat sinking effect, but this militates against improvements in element mounting or package density.

A semiconductor device according to the first part of claim 1 is known from GB-A-2 056 772.

Thus it is desirable to provide a semiconductor device, for example a semiconductor memory element, wherein a semiconductor chip is more effectively cooled than in conventional devices, thereby facilitating improved package density.

An embodiment of the present invention provides a semiconductor device comprising: a supporting member having first and second major surfaces which are formed in parallel to each other, and side surfaces which are free from lead pins and have conductive patterns formed thereon; a semiconductor chip mounted on said first surface of said supporting member; a heat sinking plate attached to said second major surface of said supporting member and electrically connected to said semiconductor chip; and a cap which is placed on said supporting member to encapsulate said semiconductor chip.

For example, an embodiment of the present invention can advantageously provide a semiconductor memory device having a chip selecting terminal which acts as a heat sinking plate, of large surface area and low thermal resistivity, and is electrically connected to a semiconductor memory chip.

Reference will now be made, by way of example, to the following additional Figures of the accompanying drawings in which:

Fig. 3A is a top plan view illustrating an embodiment according to the present invention;

Fig. 3B is a cross-sectional view taken along IIIB-IIIB line of Fig. 3A;

Fig. 3C is a cross-sectional view taken along IIIC-IIIC line of Fig. 3A;

Fig. 3D is a bottom plan view of Fig. 3A;

Fig. 4 is a cross-sectional view illustrating the embodiment illustrated in Figs. 3A to 3D horizontally mounted on a connection substrate;

Fig. 5 is a perspective view illustrating another embodiment vertically mounted on a connection substrate.

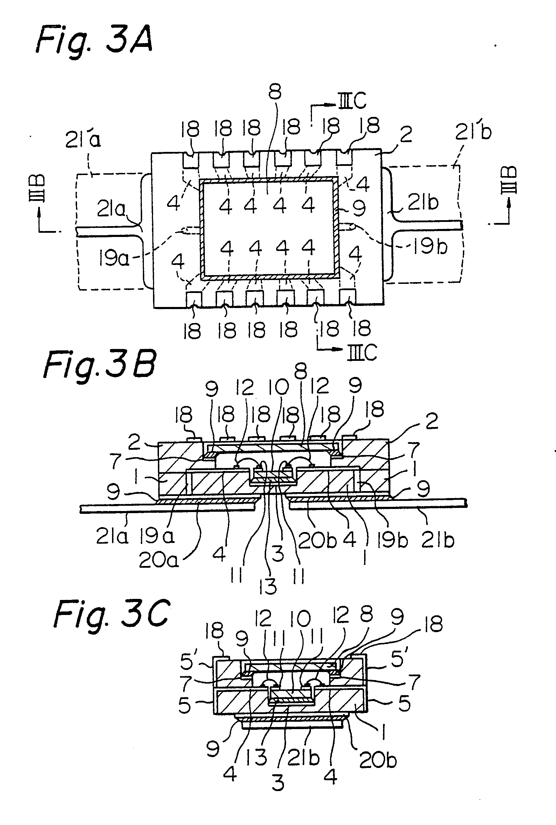

In Figs. 3A to 3C, a ceramic substrate 1 is provided with a ceramic frame 2. The ceramic substrate 1 has a recess in which a semiconductor memory chip 10 is situated on a chip stage 3 plated with, for example, gold. A desired bonding pad 11 of the semiconductor memory chip 10 is electrically connected to an exposed portion of desired inner connections 4 with aluminum bonding wire 12 which is bonded to bonding pad 11 provided on the surface of the semiconductor memory chip 10. The inner connections 4 are provided on the surface of the ceramic substrate 1. A cap 8, which seals the ceramic substrate 1 to protect the semiconductor memory chip 10, is adhered to the recess of the ceramic frame 2, which is formed in the inner side thereof, through a cap-soldering metallized layer 7 and soldering material 9, for example, a brazing alloy. The first outer connections 5 which are plated with, for example, gold are led from the inner connections 4 to two parallel sides of the ceramic substrate 1. The second outer connections 5' which are also plated with, for example, gold are formed on the two parallel surfaces of the ceramic frame 2, which surfaces extend from that of the ceramic substrate 1. The first outer connections 5 are connected to the second outer connections 5' by means of a brazing alloy. The second outer connections 5' extend to the upper surface of the ceramic frame 2 and form terminal 18 for common connections such as input or output connections or power source connections. The terminal 18 is plated with, for example, gold. Two pads 20a and 20b are formed on the lower surface of the ceramic substrate 1. The pads 20a and 20b are connected to a desired inner connection 4 via through holes 19a and 19b formed in the ceramic substrate 1. Pads 20a and 20b have adhered to them chip selecting terminals 21a and 21b which are the terminals for receiving a chip selecting signal of a memory system, having high thermal conductivity, with solder material 9 such as silver alloy.

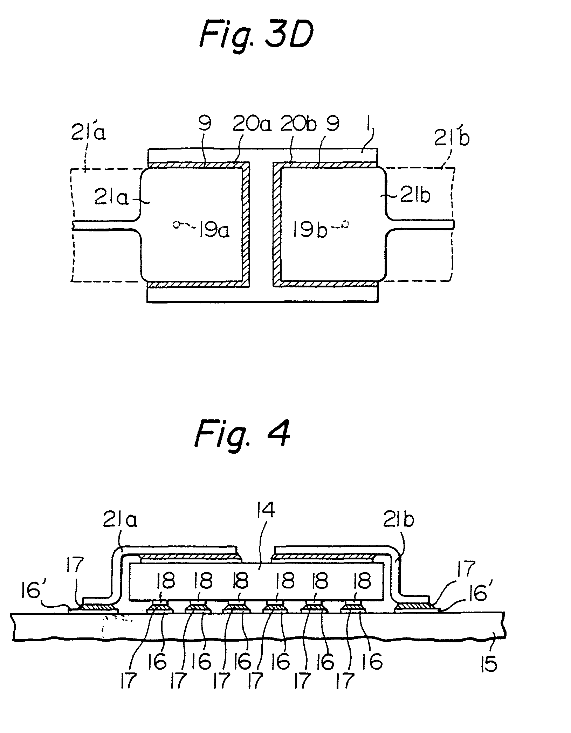

The chip selecting terminals 21a and 21b are electrically connected to a semiconductor memory chip via through holes 19a and 19b. It is preferable that the chip selecting terminals. 21a and 21b made of copper alloy or molybdenum and have a large area and a thickness of 0.3 to 0.5 mm. The ceramic frame 2 is formed so its upper surface is higher than the upper surface of the metal cap 8, so that when a conductor is mounted on the semiconductor memory element 14, the conductor does not touch the cap 8. Further, both top portions of the chip selecting terminals 21a and 21b are usually narrowed to a desired small width, as shown in Figs. 3A and 3D, so that the chip selecting terminals 21a and 21b can be easily mounted on the connection substrate 15. However, if the situation permits, it is preferable that both top portions of the chip selecting terminals are not narrowed, as shown by the broken lines 21a' and 21b' in Figs. 3A and 3D, because this shape is advantageous for effectiveness of the heat sink.

In Fig. 4, a semiconductor memory element 14 is provided on a connection substrate 15 made of ceramic or plastic through terminals 18 for common connection, solder 17, and connection patterns 16. Further, the chip selecting terminals 21a and 21b, which are widely soldered on the bottom of the semiconductor memory element 14 and are made of copper alloy, molybdenum, etc. having low thermal resistivity, are soldered on the connection substrate 15 through connection pattern 16'.

Thus, as shown by the above, a semiconductor device embodying the present invention can comprise a conventional semiconductor memory element and chip selecting terminals which act as a heat sinking plate and are electrically connected to the semiconductor chip. In an embodiment of the present invention, heat which is generated in the semiconductor memory chip (not shown in Fig. 4) during working thereof is conducted to the bottom surface of the semiconductor memory element 14 and then through the chip selecting terminals 21a and 21b to the connection substrate 15.

Since the area of connection of the chip selecting terminals 21a and 21b to the bottom surface of the ceramic substrate 1 is broad, as shown in Figs. 3A and 3D, part of the heat conducted to the chip selecting terminals 21a and 21b is radiated therefrom. Thus, the increase of temperature of the semiconductor chip can be kept to a lower level than in a conventional case. The semiconductor memory elements can therefore also be placed closer together, resulting in increased switching speed due to shorter connection lengths and increased package density.

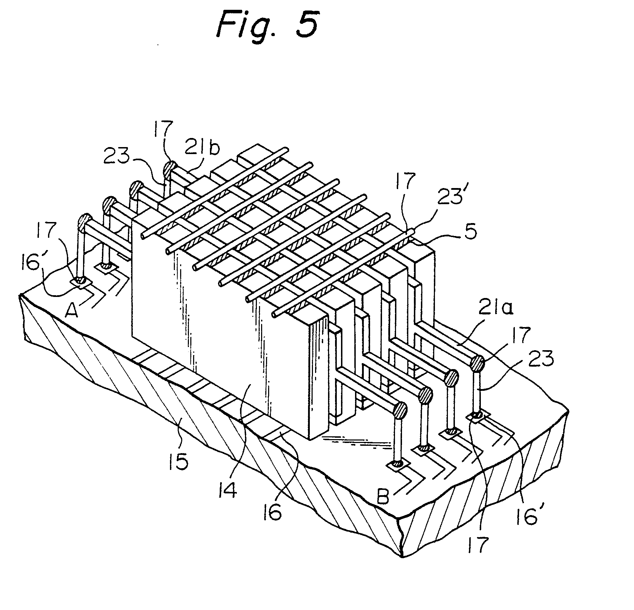

Referring to Fig. 5, a block of semiconductor memory elements 14 formed by aligning a plurality of the semiconductor memory elements vertically, is mounted on the connection substrate 15. In Fig. 5, the outer connections (not shown) for common connection provided on one side of each semiconductor memory element 14 are soldered to a common connection pattern 16 on the connection substrate 15. Each chip selecting terminal 21a and 21b is soldered to the chip selecting connection pattern 16' on the connection substrate 15 through a lead wire 23 having a diameter of 0.2 to 0.5 mm. Further, common connections consisting of a plurality of lead wires 23' having a diameter of 0.2 to 0.5 mm are soldered to the outer connections 5' for common connection provided on the other side of each semiconductor memory element. One end of the lead wire 23' is connected to the power source (not shown) or input-or output terminal by a jack (not shown). Furthermore, the sides A and B of the chip selecting connection pattern 16' are connected to a power source (not shown) and signal terminal.

In the mounting structure shown in Fig. 5, a heat sinking effect can be obtained, as mentioned above. Thus, such a mounting structure wherein blocks of semiconductor memory devices are vertically provided on the connections substrate enables significantly increased package density compared to a conventional mounting structure. Also, the length of connection can be significantly shortened, thus, increasing the switching speed of the semiconductor array.

While there are shown and described preferred embodiments of the invention, it is to be distinctly understood that the invention is not limited thereto, but maybe otherwise variously embodied and practised within the scope of the following claims.

## Claims

1. A semiconductor device comprising a semiconductor chip (10) mounted on one main face of a plate-form support member (1), a cap structure (2, 8) secured to the support member (1) so as to encapsulate the chip between the cap structure and the support member, peripheral side surfaces of the device having no electrical connecting pins projecting therefrom but being provided with electrically conductive regions (5, 5') connected respectively to electrical terminals (11) of the semiconductor chip (10) for external connection purposes, and a heat sink (21a) attached in heat-conducting relationship to the other main face of the support member (1), characterised in that the heat sink (21a) is in the form of an electrically conductive plate extending over a large area of the said other main face of the support member (1) and is electrically connected to another electrical terminal (11) of the said chip.

2. A semiconductor device according to claim 1, wherein a second electrically conductive plate-form heat sink (21b) is similarly attached to the said other main face of the support member (1) and is electrically connected to a further electrical terminal (11) of the said chip.

3. A semiconductor device according to claim 1 or claim 2, wherein said electrically conductive regions (5, 5') are arranged along a first pair of parallel peripheral surfaces of said device and the plate-form heat sink or sinks projects or project beyond the second pair of parallel side surfaces thereof.

4. A semiconductor device according to any preceding claim, wherein the or each heat sink (21a, 21b) is electrically connected to said semiconductor chip by way of a hole (19a) extending through said support member (1).

5. A semiconductor device according to any preceding claim, wherein said semiconductor chip (10) is a semiconductor memory chip.

6. A semiconductor device according to claim 5, wherein one of said heat sinks (21a, 21b) is connected to a chip selection terminal of said chip.

7. A semiconductor device comprising a stack of devices according to claims 3, 5 and 6, mounted on a connection substrate (15) with the planes of the devices at right angles thereto and with the heat sinks disposed between adjacent devices, electrically conductive regions (5, 5') along one side surface of the device being soldered to connection patterns (16) on the connection substrate (15) and said one heat sink (21a) of each device being connected to a signal terminal.

8. A semiconductor device according to any preceding claim, wherein said heat sink(s) is or are made of copper alloy or molybdenum and is or are from 0.3 to 0.5mm thick.

9. A semiconductor device as claimed in any preceding claim, wherein said plate-form support member (1) is made of ceramic or silicon carbide.

10. A semiconductor device according to any preceding claim, wherein a major part (8) of the said cap structure is made of metal and/or ceramic and/or resin.

## Patentansprüche

1. Halbleitervorrichtung mit einem Halbleiterchip (10), welches auf einer Hauptoberfläche eines plattenförmigen Stützteils (1) montiert ist, einer Kappenstruktur (2, 8), die auf dem Stützteil (1) so befestigt ist, daß sie das Chip zwischen der Kappenstruktur und dem Stützteil einkapselt, peripheren Seitenoberflächen der Vorrichtung, welche keine elektrischen Verbindungsstifte haben, die von dort vorstehen, jedoch mit elektrisch leitenden Bereichen (5, 5') versehen sind, welche jeweils mit elektrischen Anschlüssen (11) des Halbleiterchip (10) für externe Verbindungszwecke verbunden sind, und einer Wärmesenke (21a), welche in wärmeleitender Relation mit der anderen Hauptoberfläche des Stützteils (1) verbunden ist, dadurch gekennzeichnet, daß die Wärmesenke (21a) in der Form einer elektrisch leitenden Platte ist, die sich über einen großen Bereich der genannten anderen Hauptoberfläche des Stützteils (1) erstreckt und mit einem anderen elektrischen Anschluß (11) des genannten Chip elektrisch verbunden ist.

2. Halbleitervorrichtung nach Anspruch 1, bei der eine zweite elektrisch leitende plattenförmige Wärmesenke (21b) in ähnlicher Weise mit der genannten anderen Fläche des Stützteils (1) verbunden ist und mit einem weiteren elektrischen Anschluß (11) des genannten Chip elektrisch verbunden ist.

3. Halbleitervorrichtung nach Anspruch 1 oder 2, bei der die genannten elektrisch leitenden Bereiche (5, 5') längs einem ersten Paar von parallelen, peripheren Oberflächen der genannten Vorrichtung und der plattenförmigen Wärmesenke oder Wärmesenken über das zweite Paar von parallelen Seitenoberflächen davon vorstehen.

4. Halbleitervorrichtung nach einem der vorhergehenden Ansprüche, bei der die oder jede Wärmesenke (21a, 21b) mit dem genannten Halbleiterchip über ein Loch (19a) elektrisch verbunden ist, welches sich durch das genannte Stützteil (1) erstreckt.

5. Halbleitervorrichtung nach einem der vorhergehenden Ansprüche, bei der das genannte Halbleiterchip (10) ein Halbleiterspeicherchip ist.

6. Halbleitervorrichtung nach Anspruch 5, bei der eine der genannten Wärmesenken (21a, 21b) mit einem Chipauswahlanschluß des genannten Chip verbunden ist.

7. Halbleitervorrichtung mit einem Stapel von Vorrichtungen nach Ansprüchen 3, 5 und 6, der auf einem Verbindungssubstrat (15) montiert ist, mit Ebenen der Vorrichtungen in einem rechten Winkel dazu und mit den Wärmesenken zwischen benachbarten Vorrichtungen angeordnet, mit elektrisch leitenden Bereichen (5, 5′) längs einer Seitenoberfläche der Vorrichtung, die an den Verbindungsmustern (16) auf dem Verbindungssubstrat (15) angelötet sind, und bei der die genannte eine Wärmesenke (21a) von jeder Vorrichtung mit einem Signalanschluß verbunden ist.

8. Halbleitervorrichtung nach einem der vorhergehenden Ansprüche, bei der die genannte(n) Wärmesenke(n) aus Kupferlegierung oder Molybdän besteht bzw. bestehen und zwischen 0.3 und 0.5 mm dick sind.

9. Halbleitervorrichtung nach einem der vorhergehenden Ansprüche, bei der das genannte plattenförmige Stützteil (1) aus Keramik oder Siliziumkarbid hergestellt ist.

10. Halbleitervorrichtung nach einem der vorhergehenden Ansprüche, bei der ein größeres Teil (8) der genannten Kappenstruktur aus Metall und/oder Keramik und/oder Harz hergestellt ist.

**Revendications**

1. Dispositif à semiconducteurs comprenant une puce semiconductrice (10) montée sur une première face principale d'un élément de support en plate-forme (1), une structure de couvercle (2, 8) fixée à l'élément de support (1) de manière à encapsuler la puce entre la structure de couvercle et l'élément de support, les surfaces latérales périphériques du dispositif ne possédant pas de broches de connexion électrique qui en font saillie, mais étant dotées de régions électriquement conductrices (5, 5′) respectivement connectées à des bornes électriques (11) de la puce semiconductrice (10) en vue de réaliser des connexions externes, et un puits thermique d'absorption de chaleur (21a) fixé en relation de conduction de chaleur à l'autre face principale de l'élément de support (1), caractérisé en ce que le puits thermique (21a) se présente sous la forme d'une plaque électriquement conductrice s'étendant sur une grande aire de ladite autre face principale de l'élément de support (1) et est électriquement connecté à une autre borne électrique (11) de ladite puce.

2. Dispositif à semiconducteurs selon la revendication 1, où un deuxième puits thermique d'absorption de chaleur en forme de plate-forme électriquement conductrice (21b) est, de la même façon, fixé à ladite autre face principale de l'élément de support (1) et est électriquement connecté à une borne électrique supplémentaire (11) de ladite puce.

3. Dispositif à semiconducteurs selon la revendication 1 ou 2, où lesdites régions électriquement conductrices (5, 5′) sont disposées le long d'une première paire de surfaces périphériques parallèles du dispositif et le ou les puits thermiques en forme de plates-formes font saillie au-delà de la deuxième paire de surfaces latérales parallèles de celui-ci.

4. Dispositif à semiconducteurs selon l'une quelconque des revendications précédentes, où le ou chaque puits thermique (21a, 21b) est électriquement connecté à ladite puce semiconductrice par l'intermédiaire d'un trou (19a) s'étendant au travers dudit élément de support (1).

5. Dispositif à semiconducteurs selon l'une quelconque des revendications précédentes, où ladite puce semiconductrice (10) est une puce de mémoire semiconductrice.

6. Dispositif à semiconducteurs selon la revendication 5, où l'un desdits puits thermiques (21a, 21b) est connecté à une borne de sélection de puce de ladite puce.

7. Dispositif à semiconducteurs comprenant un empilement de dispositifs selon les revendications 3, 5 et 6, monté sur un substrat de connexion (15) de façon que les plans des dispositifs soient à angle droit de celui-ci et de façon que les puits thermiques soient disposés entre dispositifs adjacents, des régions électriquement conductrices (5, 5′) situées le long d'une première surface latérale du dispositif étant soudées à des configurations de connexion (16) se trouvant sur le substrat de connexion (15) et ledit premier puits thermique (21a) de chaque dispositif étant connecté à une borne de signal.

8. Dispositif à semiconducteurs selon l'une quelconque des revendications précédentes, où ledit ou lesdits puits thermiques sont faits en alliage de cuivre ou en molybdène et ont une épaisseur de 0,3 à 0,5 mm.

9. Dispositif à semiconducteurs selon l'une quelconque des revendications précédentes, où ledit élément de support en plateforme (1) est fait en céramique ou en carbure de silicium.

10. Dispositif à semiconducteurs selon l'une quelconque des revendications précédentes, où une partie principale (8) de ladite structure de couvercle est faite en métal et, ou bien, en céramique et, ou bien, en résine.

*Fig. IA*

*Fig. IB*

*Fig. 2*

## Fig. 3A

## Fig. 3B

## Fig. 3C

2

## Fig. 3D

## Fig. 4

0 078 684

# *Fig. 5*